(19) Europäisches Patentamt
European Patent Office
Office européen des brevets

(11) **EP 4 100 563 B1**

(12) **EUROPÄISCHE PATENTSCHRIFT**

(45) Veröffentlichungstag und Bekanntmachung des Hinweises auf die Patenterteilung:
**06.03.2024   Patentblatt 2024/10**

(21) Anmeldenummer: **21703840.5**

(22) Anmeldetag: **27.01.2021**

(51) Internationale Patentklassifikation (IPC):
*C30B 15/10* (2006.01)   *C03C 17/00* (2006.01)
*C30B 35/00* (2006.01)   *C03B 19/06* (2006.01)
*C03C 17/02* (2006.01)

(52) Gemeinsame Patentklassifikation (CPC):
**C30B 35/002; C03B 19/066; C03C 17/004; C03C 17/02; C30B 15/10;** C03C 2217/91

(86) Internationale Anmeldenummer:
**PCT/EP2021/051798**

(87) Internationale Veröffentlichungsnummer:
**WO 2021/156114 (12.08.2021 Gazette 2021/32)**

(54) **QUARZGLASTIEGEL ZUR HERSTELLUNG VON SILICIUMKRISTALLEN UND VERFAHREN ZUR HERSTELLUNG VON QUARZGLASTIEGEL**

QUARTZ GLASS CRUCIBLE FOR PRODUCING SILICON CRYSTALS AND PROCESS FOR PRODUCING QUARTZ GLASS CRUCIBLE

CREUSET EN VERRE DE SILICE POUR PRODUIRE DES CRISTAUX DE SILICIUM ET PROCÉDÉ DE FABRICATION D'UN CREUSET EN VERRE DE SILICE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.02.2020   DE 102020000701**

(43) Veröffentlichungstag der Anmeldung:
**14.12.2022   Patentblatt 2022/50**

(73) Patentinhaber: **Siltronic AG**
**81677 München (DE)**

(72) Erfinder:
• **LEHMANN, Toni**
**09569 Oederan (DE)**
• **ZEMKE, Dirk**
**5122 Ach (AT)**

(56) Entgegenhaltungen:
EP-A1- 2 460 911   EP-A1- 2 460 913
CN-A- 101 956 230   DE-A1-102012 011 793

## Beschreibung

Die Erfindung betrifft einen Quarzglastiegel zum Kristallziehen mit einer Tiegelwandung. Ferner betrifft die Erfindung eine Methode, um mit diesem Tiegel einen Kristall nach dem Czochralski-Verfahren zu ziehen.

Quarzglastiegel werden beispielsweise zur Aufnahme der Metallschmelze beim Ziehen von Einkristallen nach dem sogenannten Czochralski-Verfahren eingesetzt. Bei diesem Verfahren wird ein Impfkristall mit vorgegebener Orientierung in die Schmelze eingetaucht und dann langsam hochgezogen. Impfkristall und Schmelze rotieren dabei gegenläufig. Die Oberflächenspannung zwischen Impfkristall und Schmelze bewirkt, dass mit dem Impfkristall auch Schmelze abgezogen wird, die allmählich erkaltet und dadurch zu einem stetig weiterwachsenden Einkristall erstarrt.

Die gezogenen Stäbe können verwendet werden, um mit mechanischen Verfahren wie zum Beispiel einer Drahtsäge in Halbleiterscheiben (Wafer) geschnitten zu werden. Nach dem anschließenden Polieren können die so erhaltenen Wafer nach einem optionalen Schritt zur Epitaxie zur Fertigung von elektronischen Bauelementen verwendet werden.

Beim Kristallziehprozess unterliegt der Quarzglastiegel über mehrere Stunden hohen mechanischen, chemischen und thermischen Belastungen, denen er ohne merkliche plastische Verformungen standhalten muss. Je größer der Tiegel und damit das darin aufzunehmende Schmelzvolumen ist, desto länger dauern in der Regel die Schmelzzeiten.

Um die thermische Stabilität des Quarzglastiegels zu erhöhen wird in der EP 07 48 885 A1 vorgeschlagen, diesen mit einer Oberflächenschicht aus Cristobalit zu versehen. Der Schmelzpunkt von Cristobalit liegt mit etwa 1720°C deutlich oberhalb der Schmelztemperaturen üblicher Halbleitermaterialien (im Fall einer Siliciumschmelze beträgt die Schmelztemperatur beispielsweise ca. 1420°C). Zur Erzeugung der Cristobalit-Oberflächenschicht wird die glasige Außenwandung eines handelsüblichen Tiegels aus opakem, blasenhaltigem Quarzglas mit einer chemischen Lösung behandelt, die Substanzen enthält, die eine Entglasung von Quarzglas zu Cristobalit fördern ("Kristallisationspromotor"). Als Kristallisationspromotoren werden im Wesentlichen Bor-, Erdalkali- und Phosphorverbindungen empfohlen; bevorzugt wird Bariumhydroxid eingesetzt. Beim Aufheizen des Quarzglastiegels auf eine Temperatur oberhalb von 1420 °C - zum Beispiel während des Einsatzes beim Kristallziehprozess - kristallisiert die vorbehandelte Tiegelwandung oberflächlich unter Bildung von Cristobalit aus, was zu einer höheren mechanischen und thermischen Festigkeit des Quarzglastiegels beiträgt.

Die Schrift EP 1 497 484 A1 beschreibt einen Quarzglastiegel zum Kristallziehen mit einer Tiegelwandung, umfassend eine Außenschicht aus opakem Quarzglas und eine Innenschicht, wobei die Außenschicht einen inneren Bereich und einen äußeren Bereich aufweist, der mit einem Kristallisationspromotor versehen ist, der beim Aufheizen des Quarzglastiegels beim bestimmungsgemäßen Einsatz beim Kristallziehen eine Kristallisation von Quarzglas unter Bildung von Cristobalit bewirkt. Der Kristallisationspromotor enthält dabei eine in Quarzglas - zusätzlich zu Silicium - als Netzwerkbildner wirkende und/oder eine in Quarzglas als Netzwerkwandler wirkende erste Komponente und eine in Quarzglas als Trennstellenbildner wirkende, alkalimetallfreie zweite Komponente.

Die Patentschrift US 2019 145 019 A1 beschreibt, dass die Dicke der kristallisationsbeschleunigerhaltigen Beschichtungsfilme vorzugsweise 0,3 bis 100 Mikrometern beträgt. Dementsprechend wird die darauf aufgebrachte Bariumkonzentration durch Änderung der Dicke der kristallisationsbeschleunigerhaltigen Beschichtungsfilme gesteuert. Es ist zu beachten, dass Elemente, die als Kristallisationsbeschleuniger wirken können, dem Tiegelkörper aus Quarzglas nicht absichtlich zugesetzt werden, und wenn der Tiegelkörper z.B. aus natürlichem Quarzmehl besteht, ist es vorzuziehen, dass die Bariumkonzentration weniger als 0,10 ppm, die Magnesiumkonzentration weniger als 0,10 ppm und die Kalziumkonzentration weniger als 2,0 ppm beträgt. Bei der Verwendung von synthetischem Quarzmehl als Rohstoff für die innere Oberfläche des Tiegelkörpers ist es vorzuziehen, dass die Konzentrationen von sowohl Magnesium als auch Kalzium im Tiegelkörper weniger als 0,02 ppm betragen.

Die Patentschrift DE 10 2012 011793 A1 beschreibt ein Verfahren zur Herstellung eines Quarzglastiegels mit einer kristallisierbaren Oberflächenschicht: Kristalline Körnung aus natürlichem, mittels Heißchlorierung gereinigtem Quarz wird in eine um eine Rotationsachse rotierende Metallform eingefüllt. Unter der Wirkung der Zentrifugalkraft und mittels einer Schablone wird an der Innenwandung der Metallform eine rotationssymmetrische tiegelförmige Quarzkörnungs-Schicht ausgeformt. Auf der Innenwandung der Quarzkörnungs-Schicht wird mittels des bekannten Lichtbogenschmelzens eine transparente Innenschicht erzeugt. Hierzu wird unter anhaltender Rotation der Metallform hochreine, synthetische Quarzkörnung durch den Lichtbogen, der von oben in die Metallform abgesenkt wird, eingestreut. Die durch den Lichtbogen eingestreute Körnung wird erweicht und gegen die Innenwandung der Quarzkörnungs-Schicht geschleudert und darauf aufgeschmolzen. An der Innenwandung wird eine Maximaltemperatur von über 2100°C erreicht und es bildet sich eine nach außen, in Richtung auf die Metallform, fortschreitende Schmelzfront, in deren Folge die Innenschicht zu einem transparentem Quarzglas erschmolzen und die Quarzkörnungs-Schicht zu einer Außenschicht aus opakem Quarzglas gesintert wird. Die Außenwandung der so hergestellten Rohform wird von anhaftender Quarzkörnung befreit und anschließend abgeschliffen. Die Wandung des so erhaltenen Tiegelbasiskörpers wird somit von einer glatten, glasigen, blasenfreien, hochreinen Innenschicht aus synthetisch erzeugtem $SiO_2$ mit einer Dicke von etwa 1,5 mm gebildet, die mit der Außenschicht mit einer Dicke um 15 mm fest verbunden ist. Auf der Innenwandung des Tiegelbasiskörpers wird anschließend eine Schicht erzeugt, die einen Kristallisationspromotor enthält.

Die Erfinder haben erkannt, dass die Verwendung der Tiegel, die nach dem derzeitigen Stand der Technik hergestellt werden, nach wie vor Nachteile hinzunehmen sind. Insbesondere das Ziehen mehrere Kristalle aus einem Tiegel erleidet vielfach Schaden, da die Kristalle eine erhöhte Versetzungsrate aufweisen und daher für die Halbleiterindustrie nicht oder nur teilweise verwendet werden können. Die Erfinder haben auch erkannt, dass die lange Zeit, die ein Tiegel hohen Temperaturen ausgesetzt ist, zu Versetzungen führt. Dies ist insbesondere bei großen Durchmessern und hohen Einwaagen der Fall. Aber gerade da wäre es wirtschaftlich besonders reizvoll, Tiegel verwenden zu können, die die genannten Nachteile nicht zeigen.

Zudem zeigt es sich, Kristalle, die nacheinander aus einem Tiegel gezogen wurden, deutliche Qualitätsunterschiede aufweisen. So sinkt zum Beispiel die charakteristische mittlere freie Weglänge der Minoritätsladungsträger der Kristalle, mit zunehmender Anzahl der Kristalle die aus einem Tiegel schon gezogen wurden. Diese Qualitätsunterschiede je nachdem, wie viele Kristalle schon aus einem Tiegel gezogen wurden, ist für die Halbleiterindustrie nicht akzeptabel.

Aus der beschriebenen Problematik ergab sich die Aufgabenstellung der Erfindung, nämlich Quarztiegel zur Verfügung zu stellen, die die genannten Nachteile beim Kristallziehen nicht entfalten. Ferner ist es Aufgabe, Verfahren zur Verfügung zu stellen geeignete Quarztiegel herzustellen.

Die Aufgabe der Erfindung wird gelöst durch die in den Ansprüchen beschriebenen Verfahren und Produkte.

Die bezüglich der vorstehend aufgeführten Ausführungsformen des erfindungsgemäßen Verfahrens angegebenen Merkmale können entsprechend auf das erfindungsgemäße Produkt übertragen werden. Umgekehrt können die bezüglich der vorstehend ausgeführten Ausführungsformen des erfindungsgemäßen Produkts angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

## Kurzbeschreibung der Figuren

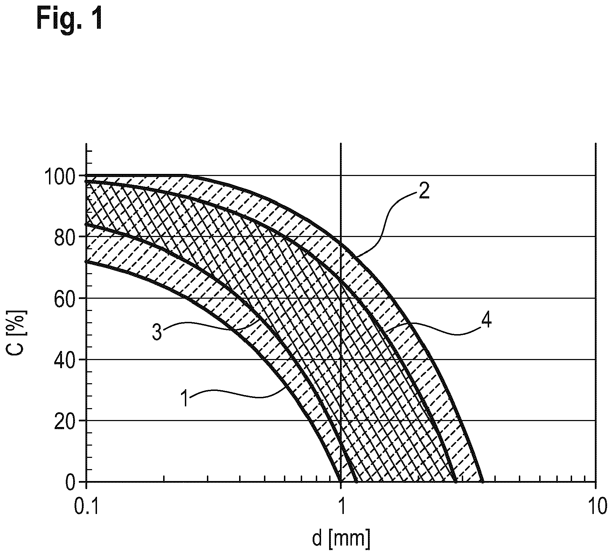

**Figur 1** zeigt eine erfindungsgemäße minimale und maximale Konzentration C des synthetisch gewonnenen $SiO_2$ als Funktion der Entfernung d von der inneren Oberfläche des Quarztiegels. Das bevorzugte Konzentrationsprofil befindet sich zwischen Kurve 1 und Kurve 2. und das besonders bevorzugtes Konzentrationsprofil befindet sich zwischen Kurve 3 und Kurve 4.

Aus experimentellen Daten wurde eine empirische Abbildungsvorschrift für die jeweiligen Grenzen entwickelt.

Kurve **1** kann demnach mit der Abbildungsvorschrift C [%] <= 100 - (d [mm] - 0,25) x 30 und Kurve **2** mit der Abbildungsvorschrift C [%] >= 100 - (d [mm] + 0,25) x 80mathematisch beschrieben werden.

Die Erfinder haben erkannt, dass ein noch größerer Effekt in dem Bereich zwischen Kurve **3** und Kurve **4** zu finden ist. Diese Kurven **3** und **4** können gut mit den jeweiligen mathematischen Vorschriften C [%] >= 100 - (d [mm]-0,05) x 36 und C [%] <= 100 - (d [mm] + 0,1) x 80 beschrieben werden.

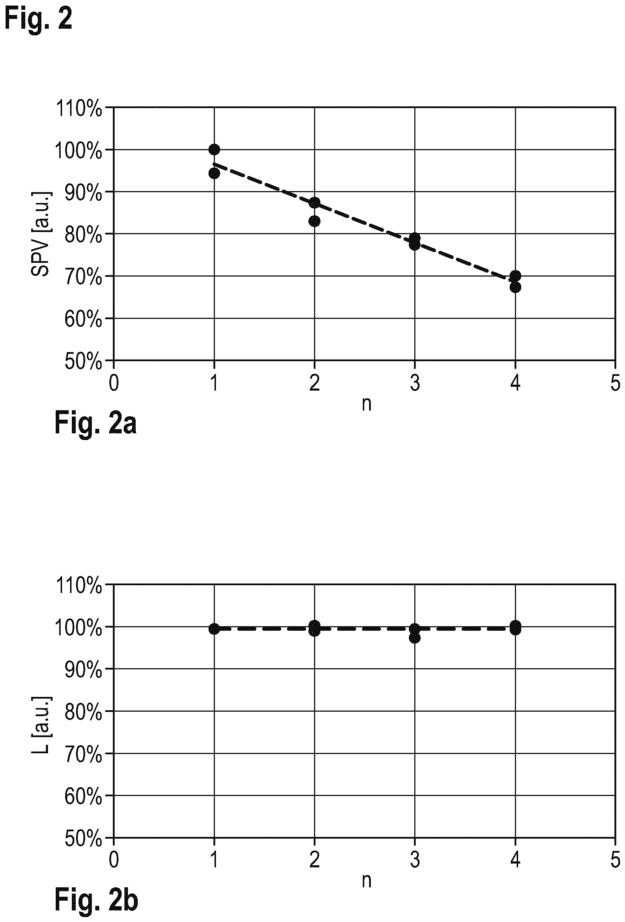

Die Graphiken in den **Figuren 2, 3** und **4** illustrieren Messergebnisse, die erhalten werden, wenn mehrere Kristalle (Abszisse) aus einem Tiegel gezogen werden.

Die mit "**SPV**" bezeichneten Ordinaten geben dabei die charakteristische mittlere freie Weglänge der Minoritätsladungsträger (SPV) des jeweiligen Kristalls (Abszisse) in relativen Einheiten bezogen auf den Maximalwert wieder.

Die mit "**L**" bezeichneten Ordinaten geben die Länge des versetzungsfreien Anteils des jeweiligen Kristalls (Abszisse) wieder.

Kristalle, deren Daten in Figuren **2a** und **2b** gezeigt werden, wurden mit einem Tiegel gezogen, der -wie im Stand der Technik beschrieben- aus natürlich gewonnenem $SiO_2$ hergestellt wurde und dessen Innenseite mit einer Barium enthaltenden Komponente beschichtet wurde.

Zwar zeigt sich, dass die Länge des versetzungsfreien Anteils der Kristalle hoch bleibt, dennoch ist ein erhebliches Absinken der mittleren freien Weglänge ersichtlich. So sinkt die mittlere freie Weglänge im Mittel auf 70% des Anfangswertes ab. Es ist also nicht gegeben, dass Kristalle mit gleicher Qualität mit einem Tiegel hergestellt werden können.

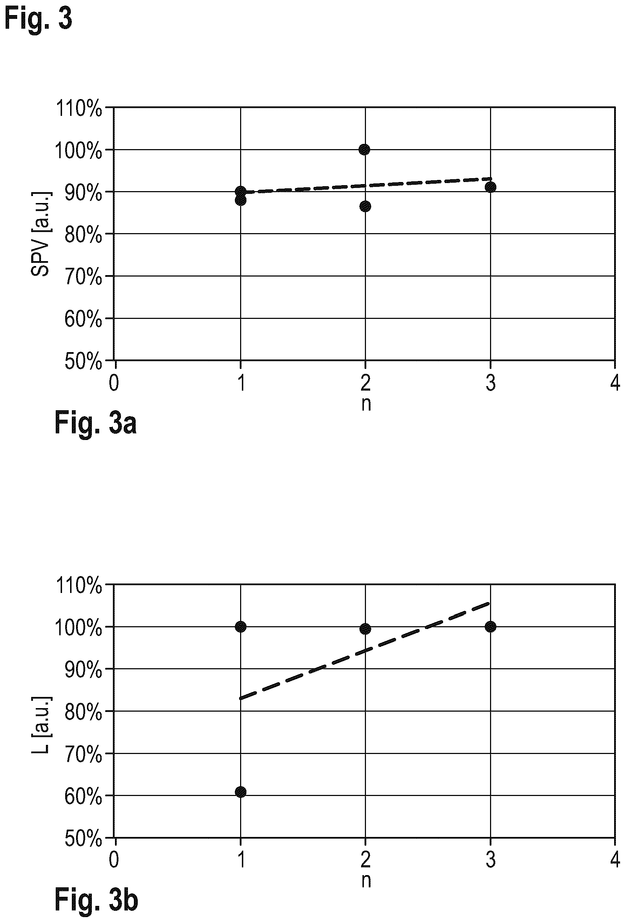

Kristalle, deren Daten in Figuren **3a** und **3b** gezeigt werden, wurden mit einem Tiegel gezogen, der -wie im Stand der Technik beschrieben- aus synthetisch gewonnenem $SiO_2$ hergestellt wurde und dessen Innenseite mit einer Barium enthaltenden Komponente beschichtet wurde.

Die normalisierten Werte (Figur **3a**) für die freie Weglänge zeigen eine deutlich erhöhte Streuung. Selbst der erste Kristall aus dem verwendeten Tiegel zeigt eine um im Mittel 10% kleinere mittlere freie Weglänge. Kristalle dieser Qualität sind für die Halbleiterindustrie nicht ausreichend. Auch die Länge des versetzungsfreien Anteils der Kristalle (Figur **3b**) zeigt eine inakzeptable Streuung und würde für einen entsprechenden wirtschaftlichen Schaden führen.

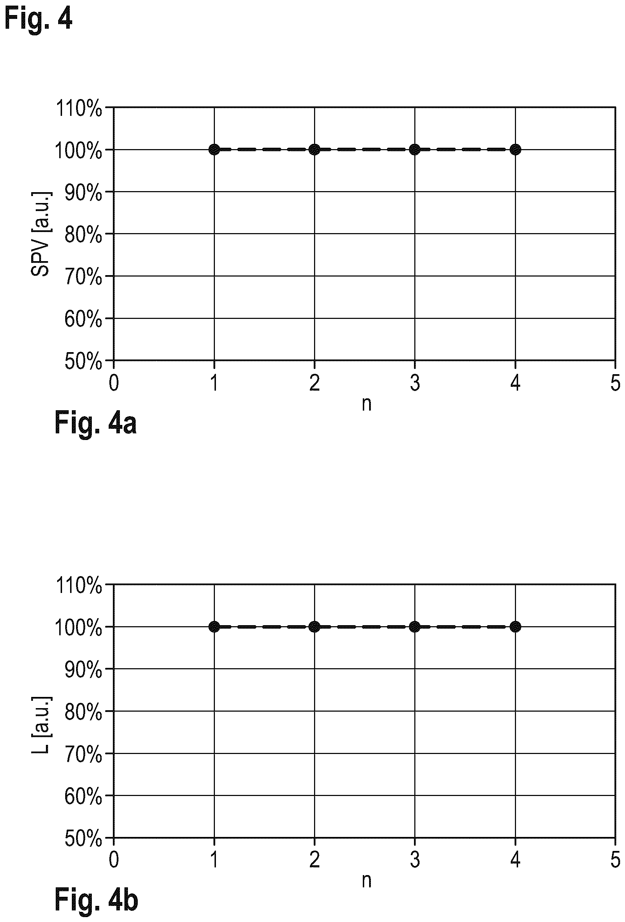

In den Figuren **4a** und **4b** werden die Ergebnisse von Kristallen gezeigt, die mit einem erfindungsgemäß hergestellten Tiegel gezogen wurden.

Es ist deutlich sichtbar, dass sowohl die mittlere freie Weglänge (Figur **4a**) als auch der Anteil der versetzungsfreien Länge der Kristalle (Figur **4b**) nur minimale (keine) Streuung zeigen. Sowohl für die Qualität als auch für die Wirtschaftlichkeit sind die erfindungsgemäßen Tiegel optimal.

**Detaillierte Beschreibung erfindungsgemäßer Ausführungsbeispiele**

Es wurden jeweils mehrere Kristalle aus einem Tiegel mittels dem Ziehverfahren nach Czochralski gezogen und sowohl die mittlere freie Weglänge der Minoritätsladungsträger (SPV) als auch die Länge des nicht versetzten Kristalls gemessen. Die Länge des nicht versetzten Anteils des Kristalls wurde in Relation zur theoretisch erreichbaren Gesamtlänge gesetzt.

Ebenso wurde die charakteristische mittlere freie Weglänge der Minoritätsladungsträger in Relation zur gemessenen maximalen gemessenen mittleren freien Weglänge gesetzt. Diese Maßzahl dient im Folgenden als Qualitätskriterium für eventuelle Verunreinigungen, die im Kristall vorhanden sein könnten, die die später auf dem Silicium gefertigten Bauelemente zu stören. Theoretisch könnten auch andere Maßzahlen für die Qualität der Kristalle verwendet werden. Als Beispiele hierfür ist eine Lebensdauermessung nach μPCD oder auch eine chemische Analytik des erhaltenen Siliciums mit ICP-MS. Dem Fachmann stehen hier einige geeignete Verfahren zur Verfügung.

Die Erfinder haben die oben beschriebenen Methoden zur Messung als die geeigneten und vor allem leicht zugänglich identifiziert.

Dabei haben die Erfinder erkannt, dass die Verwendung von Tiegel, die nach dem Stand der Technik gefertigt wurden, deutliche Nachteile aufweisen, wenn ein Tiegel verwendet wird, um mehrere Kristalle nacheinander nach der Czochralski-Methode zu ziehen. Außerdem erschien es umso schwieriger, je länger das Ziehverfahren dauerte.

Die Ergebnisse der Untersuchungen sind in **Figur 2** und **Figur 3** wiedergegeben.

Kristalle, deren Daten in Figuren **2a** und **2b** gezeigt werden, wurden mit einem Tiegel gezogen, der -wie im Stand der Technik beschrieben- aus natürlich gewonnenem $SiO_2$ hergestellt wurde und dessen Innenseite mit einer Barium enthaltenden Komponente beschichtet wurde.

Zwar zeigt sich, dass die Länge des versetzungsfreien Anteils der Kristalle hoch bleibt, dennoch ist ein erhebliches Absinken der mittleren freien Weglänge ersichtlich.

So sinkt die mittlere freie Weglänge im Mittel auf 70% des Anfangswertes ab. Es ist also nicht gegeben, dass Kristalle mit gleicher Qualität mit einem Tiegel hergestellt werden können.

Kristalle, deren Daten in Figuren **3a** und **3b** gezeigt werden, wurden mit einem Tiegel gezogen, der -wie im Stand der Technik beschrieben- aus synthetisch gewonnenem $SiO_2$ hergestellt wurde und dessen Innenseite mit einer Barium enthaltenden Komponente beschichtet wurde.

Die normalisierten Werte (Figur **3a**) für die freie Weglänge zeigen eine deutlich erhöhte Streuung. Selbst der erste Kristall aus dem verwendeten Tiegel zeigt eine um im Mittel 10% kleinere mittlere freie Weglänge. Kristalle dieser Qualität sind für die Halbleiterindustrie nicht ausreichend. Auch die Länge des versetzungsfreien Anteils der Kristalle (Figur **3b**) zeigt eine inakzeptable Streuung und würde für einen entsprechenden wirtschaftlichen Schaden führen.

Die Erfinder haben das Tiegelmaterial als Ursache für die gemessenen Defizite identifiziert und umfangreiche Versuche unternommen, die Defizite zu eliminieren.

Aus der Literatur ist bekannt, dass β-Cristobalit eine höhere Schmelztemperatur als Quarz aufweist. Ferner ist bekannt, dass es bestimmte Kristallisationspromotoren gibt, die manchmal die Erzeugung von β-Cristobalit begünstigen.

Auch ist bekannt, dass Quarztiegel aus synthetisch gewonnenen $SiO_2$ andere Eigenschaften aufweisen, als Quarztiegel aus natürlich gewonnenen $SiO_2$. Die Ergebnisse der Experimente sind zum Beispiel in den Figuren **2** und **3** gezeigt.

Überaschenderweise entdeckten die Erfinder, dass ein Quarzglastiegel, mit einer Innenseite, auf der sich eine Innenschicht aus Quarzglas befindet, die eine Oberfläche bildet, wobei die Innenschicht mit einem Kristallisationspromotor versehen ist positive Eigenschaften in Bezug auf das mehrfache Kristallziehen aus einem Tiegel zeigt, nämlich dann, wenn die Konzentration von synthetisch gewonnenen $SiO_2$ C in einer Entfernung von der Oberfläche größer ist als die Konzentration von synthetisch gewonnenen SiO2 in einer weiteren Entfernung von der Oberfläche.

Besonders bevorzugt wirken dabei die Stoffe Barium oder Strontium Kristallisationspromotor, wobei Barium ganz besonders bevorzugt wird.

Die Erfinder haben erkannt, dass es bevorzugt ist, wenn die Konzentration von synthetisch gewonnenen $SiO_2$ C größer ist als 90% wenn der Abstand zur Oberfläche kleiner ist als 0,4 mm beträgt.

Weitere Versuche ergaben in unerwarteter Weise, dass, wenn für die Konzentration von synthetisch gewonnenen $SiO_2$ in Abhängigkeit des Abstandes d folgende Relationen gilt:

$$C \text{ [\%]} <= 100 - (d \text{ [mm]} - 0{,}25) \times 30$$

und

$$C\,[\%] >= 100 - (d\,[mm] + 0{,}25) \times 80$$

es sowohl in Bezug auf die Qualität (SPV) als auch auf den Anteil versetzungsfreien Länge des Kristalls sich Vorteile ergeben. Der eben beschriebene Bereich ist in Figur 1 dargestellt und betrifft den schraffierten Bereich zwischen Kurve 1 und Kurve 2.

Ergebnisse sind zum Beispiel in den Figuren 4a und 4b dargestellt.

Den Erfindern gelang es, den Bereich durch weitere Experimente etwas einzuengen und fanden, dass, wenn für die Konzentration von synthetisch gewonnenen SiO2 in Abhängigkeit des Abstandes d folgende Relationen gilt

$$C\,[\%] <= 100 - (d\,[mm] + 0{,}1) \times 80$$

$$\text{und } C\,[\%] >= 100 - (d\,[mm] - 0{,}05) \times 36,$$

es sowohl in Bezug auf die Qualität (SPV) als auch auf den Anteil versetzungsfreien Länge des Kristalls sich weitere Vorteile ergeben.

Auch dieser beschriebene Bereich ist in Figur 1 illustriert und betrifft den schraffierten Bereich zwischen Kurve 3 und Kurve 4.

Besonders bevorzugt ist dabei die Konzentration des Kristallpromotors kleiner ist als 1 ppba und größer ist als 0,05 ppba bezogen auf Silicum.

Für das Herstellen der erfindungsgemäßen Quarzglastiegel bevorzugt ist ein Verfahren enthaltend einen Kristallisationspromotor, indem ein eine Innenseite aufweisender Tiegelbasiskörper enthaltend natürlich gewonnenes $SiO_2$ hergestellt wird, und Beschichten der Innenseite mit einer Schicht die synthetisch gewonnenes $SiO_2$ enthält, wobei die Konzentration C des synthetisch gewonnenen $SiO_2$ mit zunehmender Schichtdicke zunimmt.

Besonders bevorzugt ist, dabei, wenn der Kristallisationspromotor schon bei der Herstellung des Tiegelbasiskörpers hinzugefügt wird.

Für das Verfahren wird das zur Beschichtung vorgesehene Material

in einem Mischbehälter kontinuierlich durchmischt, um Entmischung zu verhindern. Dabei werden die Anteile an synthetisch gewonnenen und natürlich gewonnenen $SiO_2$ im Mischbehälter zeitlich verändert. Gleichzeitig wird aus dem Mischbehälter Material für die Beschichtung entnommen. Idealerweise wird der Anteil des synthetisch gewonnenen Materials im Behälter mit der Zeit erhöht.

Als besonders vorteilhaft hat es sich erwiesen, dass bereits beim Beschichten der Innenseite ein Kristallisationspromotor hinzugegeben wird.

Besonders bevorzugt ist, dass im Anschluss an die Beschichtung der Tiegel mit Polysilicium gefüllt wird und auf über 1400°C aufgeheizt wird, um das Polysilicium zu schmelzen.

Ganz besonders bevorzugt ist, dass dem Polysilicium zusätzlich ein Kristallisationspromotor -bevorzugt enthaltend Barium- mit einer Konzentration größer als 0,5 ppba und kleiner als 10 ppba bezogen auf das Polysilicium beigefügt wird.

**Patentansprüche**

**1.** Quarzglastiegel zum Ziehen eines Einkristalls aus Silicium nach der Czochralski Methode,

mit einer Innenseite, auf der sich eine Innenschicht aus Quarzglas befindet, die eine Oberfläche bildet,
wobei die Innenschicht mit einem Kristallisationspromotor versehen ist, der beim Aufheizen des Quarzglastiegels beim bestimmungsgemäßen Einsatz beim Kristallziehen eine Kristallisation von Quarzglas unter Bildung von β-Cristobalit bewirkt,
**dadurch gekennzeichnet, dass** die Konzentration von synthetisch gewonnenen $SiO_2$ C in einer Entfernung d von der Oberfläche größer ist als die Konzentration von synthetisch gewonnenen $SiO_2$ in einer Entfernung d2 von der Oberfläche, wobei d2 größer ist als d, und
dass für die Konzentration von synthetisch gewonnenen SiO2 C in Abhängigkeit des Abstandes d folgende Relationen gelten:

$$C\ [\%] <= 100 - (d\ [mm] - 0{,}25) \times 30$$

und

$$C\ [\%] >= 100 - (d\ [mm] + 0{,}25) \times 80.$$

2. Quarzglastiegel nach Anspruch 1, **dadurch gekennzeichnet, dass** der besagte Kristallisationspromotor Barium oder Strontium enthält.

3. Quarzglastiegel nach Anspruch 1 oder Anspruch 2, **dadurch gekennzeichnet, dass** die Konzentration von synthetisch gewonnenen $SiO_2$ C größer ist als 90% wenn der Abstand zur Oberfläche d kleiner ist als 0,4 mm.

4. Quarzglastiegel nach einem der Ansprüche 1 bis 3, **dadurch gekennzeichnet, dass** für die Konzentration von synthetisch gewonnenen $SiO_2$ C in Abhängigkeit des Abstandes d folgende Relationen gelten:

$$C\ [\%] <= 100 - (d\ [mm] + 0{,}1) \times 80$$

$$\text{und } C\ [\%] >= 100 - (d\ [mm] - 0{,}05) \times 36$$

5. Quarzglastiegel nach einem der Ansprüche 1 bis 4, **dadurch gekennzeichnet, dass** die Konzentration des Kristallpromotors kleiner ist als 1 ppba und größer ist als 0,05 ppba bezogen auf Silicium im Quarzglastiegel.

6. Quarzglastiegel nach einem der Ansprüche 1 bis 5, **dadurch gekennzeichnet, dass** der Kristallpromotor Barium enthält.

7. Verfahren zur Herstellung eines Quarzglastiegels enthaltend einen Kristallisationspromotor,

indem ein eine Innenseite aufweisender Tiegelbasiskörper enthaltend natürlich gewonnenes $SiO_2$ hergestellt wird,
und Beschichten der Innenseite mit einer Schicht die synthetisch gewonnenes $SiO_2$ enthält, wobei die Konzentration C des synthetisch gewonnenen $SiO_2$ mit zunehmender Schichtdicke zunimmt,
**dadurch gekennzeichnet, dass**
das zur Beschichtung vorgesehene Material in einem Mischbehälter kontinuierlich durchmischt wird, um Entmischung zu verhindern, wobei die Anteile an synthetisch gewonnenen und natürlich gewonnenen $SiO_2$ im Mischbehälter zeitlich verändert werden und gleichzeitig daraus Material für die Beschichtung entnommen wird..

8. Verfahren nach Anspruch 7, **dadurch gekennzeichnet, dass** der Kristallisationspromotor bei der Herstellung des Tiegelbasiskörpers hinzugefügt wird.

9. Verfahren nach einem der Ansprüche 7 bis 8, **dadurch gekennzeichnet, dass** beim Beschichten der Innenseite ein Kristallisationspromotor hinzugegeben wird.

10. Verfahren nach einem der Ansprüche 7 bis 9, **dadurch gekennzeichnet, dass** im Anschluss an die Beschichtung der Tiegel mit Polysilicium gefüllt wird und auf über 1400°C aufgeheizt wird, um das Polysilicium zu schmelzen.

11. Verfahren nach Anspruch 10, **dadurch gekennzeichnet, dass** dem Polysilicium zusätzlich ein Kristallisationspromotor mit einer Konzentration größer als 0,5 ppba und kleiner als 10 ppba bezogen auf das Polysilicium beigefügt wird.

12. Verfahren nach einem der Ansprüche 7 bis 11, **dadurch gekennzeichnet, dass** der Kristallisationspromotor Barium enthält.

13. Verfahren zur Herstellung von Halbleiterscheiben, **dadurch gekennzeichnet, dass** ein Stab in einer Kristallziehanlage unter Verwendung eines Quarzglastiegels nach einem der Ansprüche 1 bis 6 gezogen wird, mittels einer Drahtsäge zu Wafern geschnitten, poliert und optional einer Epitaxie unterzogen wird.

**Claims**

1. Fused quartz crucible for pulling a single crystal of silicon according to the Czochralski technique, having an inner side on which there is located an inner layer of fused quartz that forms a surface, the inner layer being provided with a crystallization promoter which on heating of the fused quartz crucible in the context of its designated use, in crystal pulling, brings about crystallization of fused quartz to form b-cristobalite,**characterized in that** the concentration C of synthetically obtained $SiO_2$ at a distance d from the surface is greater than the concentration of synthetically obtained $SiO_2$ at a distance d2 from the surface, where d2 is greater than d, and
**in that** the concentration C of synthetically obtained $SiO_2$ as a function of the distance d is subject to the following relationships: C [%] <= 100 - (d [mm] - 0.25) x 30 and C [%] >= 100 - (d [mm] + 0.25) x 80.

2. Fused quartz crucible according to Claim 1, **characterized in that** said crystallization promoter comprises barium or strontium.

3. Fused quartz crucible according to Claim 1 or Claim 2, **characterized in that** the concentration C of synthetically obtained $SiO_2$ is greater than 90% when the distance d to the surface is less than 0.4 mm.

4. Fused quartz crucible according to any of Claims 1 to 3, **characterized in that** the concentration C of synthetically obtained $SiO_2$ as a function of the distance d is subject to the following relationships: C [%] <= 100 - (d [mm] + 0.1) x 80 and C [%] >= 100 - (d [mm] - 0.05) x 36.

5. Fused quartz crucible according to any of Claims 1 to 4, **characterized in that** the concentration of the crystal promoter is less than 1 ppba and greater than 0.05 ppba, based on silicon in the fused quartz crucible.

6. Fused quartz crucible according to any of Claims 1 to 5, **characterized in that** the crystal promoter comprises barium.

7. Method for producing a fused quartz crucible comprising a crystallization promoter, by producing a crucible base body which has an inner side and comprises naturally obtained $SiO_2$, and coating the inner side with a layer comprising synthetically obtained $SiO_2$, the concentration C of the synthetically obtained $SiO_2$ increasing with increasing layer thickness,
**characterized in that**
the material intended for the coating is mixed continuously in a mixing vessel in order to prevent separation, with the fractions of synthetically obtained and naturally obtained $SiO_2$ in the mixing vessel being altered over time and at the same time material being withdrawn therefrom for the coating.

8. Method according to Claim 7, **characterized in that** the crystallization promoter is added during the production of the crucible base body.

9. Method according to either of Claims 7 and 8, **characterized in that** during coating of the inner side, a crystallization promoter is added.

10. Method according to any of Claims 7 to 9, **characterized in that** subsequent to the coating, the crucible is filled with polysilicon and is heated to above 1400°C in order to melt the polysilicon.

11. Method according to Claim 10, **characterized in that** the polysilicon is additionally admixed with a crystallization promoter having a concentration greater than 0.5 ppba and less than 10 ppba, based on the polysilicon.

12. Method according to any of Claims 7 to 11, **characterized in that** the crystallization promoter comprises barium.

13. Method for producing semiconductor wafers, **characterized in that** an ingot is pulled in a crystal pulling unit, using a fused quartz crucible according to any of Claims 1 to 6, the ingot is cut into wafers by means of a wire saw, the wafers are polished, and optionally they are subjected to epitaxy.

**Revendications**

1. Creuset en verre de silice destiné au tirage d'un monocristal de silicium selon le procédé de Czochralski,

présentant une face interne, sur laquelle se trouve une couche interne de verre de silice qui forme une surface, la couche interne étant munie d'un promoteur de cristallisation qui, lors du chauffage du creuset en verre de silice dans l'utilisation conforme à l'usage prévu, provoque lors du tirage de cristal une cristallisation du verre de silice avec formation de β-cristobalite,

**caractérisé en ce que** la concentration C de $SiO_2$, obtenu par synthèse, à une distance d de la surface est supérieure à la concentration de $SiO_2$, obtenu par synthèse, à une distance d2 de la surface, d2 étant supérieure à d, et

**en ce que** pour la concentration C de $SiO_2$ obtenu par synthèse, en fonction de la distance d, les relations suivantes s'appliquent :

$$C \ [\%] \ \leq \ 100 \ - \ (d \ [mm] \ - \ 0,25) \ x \ 30$$

et

$$C \ [\%] \ \geq \ 100 \ - \ (d \ [mm] \ + \ 0,25) \ x \ 80.$$

2. Creuset en verre de silice selon la revendication 1, **caractérisé en ce que** ledit promoteur de cristallisation contient du baryum ou du strontium.

3. Creuset en verre de silice selon la revendication 1 ou la revendication 2, **caractérisé en ce que** la concentration C de $SiO_2$ obtenu par synthèse est supérieure à 90 % lorsque la distance par rapport à la surface d est inférieure à 0,4 mm.

4. Creuset en verre de silice selon l'une quelconque des revendications 1 à 3, **caractérisé en ce que** pour la concentration C de $SiO_2$ obtenu par synthèse, en fonction de la distance d, les relations suivantes s'appliquent :

$$C \ [\%] \ \leq \ 100 \ - \ (d \ [mm] \ + \ 0,1) \ x \ 80$$

$$et \ C \ [\%] \ \geq \ 100 \ - \ (d \ [mm] \ - \ 0,05) \ x \ 36.$$

5. Creuset en verre de silice selon l'une quelconque des revendications 1 à 4, **caractérisé en ce que** la concentration du promoteur de cristallisation est inférieure à 1 ppba et est supérieure à 0,05 ppba par rapport au silicium dans le creuset en verre de silice.

6. Creuset en verre de silice selon l'une quelconque des revendications 1 à 5, **caractérisé en ce que** le promoteur de cristallisation contient du baryum.

7. Procédé pour la fabrication d'un creuset en verre de silice contenant un promoteur de cristallisation, par production d'un corps de base de creuset présentant une face interne, contenant du $SiO_2$ obtenu par synthèse, et revêtement de la face interne avec une couche qui contient du $SiO_2$ obtenu par synthèse, la concentration C du SiO2 obtenu par synthèse augmentant avec une épaisseur de couche croissante,
**caractérisé en ce que**
la matière prévue pour le revêtement est homogénéisée en continu dans un récipient de mélange, afin d'empêcher une démixtion, les proportions de SiO2 obtenu par synthèse et obtenu naturellement dans le récipient de mélange étant modifiées au cours du temps et de la matière pour le revêtement étant simultanément prélevée de ce dernier.

8. Procédé selon la revendication 7, **caractérisé en ce que**
le promoteur de cristallisation est ajouté lors de la production du corps de base de creuset.

9. Procédé selon l'une quelconque des revendications 7 et 8, **caractérisé en ce que**
lors du revêtement de la face interne un promoteur de cristallisation est ajouté.

10. Procédé selon l'une quelconque des revendications 7 à 9, **caractérisé en ce**
**qu'**à la suite du revêtement le creuset est rempli avec du polysilicium et est chauffé à plus de 1 400 °C, afin de faire fondre le polysilicium.

**11.** Procédé selon la revendication 10, **caractérisé en ce qu'**au polysilicium est en outre ajouté un promoteur de polysilicium à une concentration supérieure à 0,5 ppba et inférieure à 10 ppba, par rapport au polysilicium.

**12.** Procédé selon l'une quelconque des revendications 7 à 11, **caractérisé en ce que** le promoteur de cristallisation contient du baryum.

**13.** Procédé pour la fabrication de plaquettes semiconductrices, **caractérisé en ce qu'**une barre est tirée dans une installation de tirage de cristaux avec utilisation d'un creuset en verre de silice selon l'une quelconque des revendications 1 à 6, découpée en plaquettes au moyen d'une scie à fil, polie et en option soumise à une épitaxie.

Fig. 1

## Fig. 2

Fig. 2a

Fig. 2b

# Fig. 3

## Fig. 3a

## Fig. 3b

## Fig. 4

### Fig. 4a

### Fig. 4b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0748885 A1
- EP 1497484 A1
- US 2019145019 A1
- DE 102012011793 A1